# EUROPÄISCHE PATENTANMELDUNG

(11) **EP 1 737 132 A1**
(43) Veröffentlichungstag der Anmeldung: **27.12.2006**
(21) Anmeldenummer: 06008577.6
(22) Anmeldetag: 26.04.2006
(51) Int. Cl.: H03M 13/09

(54) **Verfahren zur Berechnung von CRC-Prüfwerten und Logikschaltung**

(30) Priorität: 25.06.2005 DE 102005029515
(71) Anmelder: Bosch Rexroth AG, 70184 Stuttgart (DE)
(72) Erfinder: Schmid, Thomas, 97840 Hafenlohr (DE); Schultze, Stephan, Dr., 97816 Lohr (DE); Rüppel, Wolfgang, 97833 Frammersbach (DE)

(57) **Zusammenfassung**

Es wird ein Verfahren zur Berechnung von CRC-Prüfwerten (204b, 204d) für Datenblöcke (203d, 203e) bei einer Datenübertragung vorgestellt, wobei eine dedizierte Logikschaltung (200) für die Berechnung verwendet wird, sowie eine Logikschaltung (200), die zur Berechnung von CRC-Prüfwerten (204b, 204d) für Datenblöcke (203d, 203e) bei einer Datenübertragung dediziert ist. Damit lässt sich die Berechnung von CRC-Prüfwerten bei der Datenübertragung vorteilhaft beschleunigen.

## Beschreibung

Die vorliegende Erfindung betrifft ein Verfahren zur Berechnung von CRC-Prüfwerten für Datenblöcke bei einer Datenübertragung und eine Logikschaltung.

### Stand der Technik

Bei der zyklischen Redundanzprüfung (cyclic redundancy check, CRC) handelt es sich um ein Verfahren aus der Informationstechnologie zur Bestimmung eines Prüfwerts für Daten (z.B. Netzwerkverkehr oder eine Datei), um Fehler bei der Übertragung oder Duplizierung von Daten erkennen zu können.

CRC-Prüfwerte werden häufig auch als CRC-Prüfsummen bezeichnet, obwohl es sich im eigentlichen Sinne um Prüfdivisionsreste und nicht um Summen handelt. Bei der CRC wird ein Datenblock durch ein CRC-Polynom modulo dividiert. Der Divisionsrest stellt den CRC-Prüfwert dar.

CRC-Typen werden anhand des verwendeten CRC-Polynoms unterschieden. Nach der Bitlänge der Polynome richtet sich die Länge des prüfbaren Datenblocks. Es existieren bekannte Standard-Polynome, wie z.B.:
CRC-CCITT (CRC-16): 0x11021
IBM-CRC-16: 0x18005
IEEE-802 CRC (CRC-32): 0x104C11DB7
CRC32/4: 11EDC6F41
CAN-CRC: 0xC599
Bluetooth: 0x35

Bei der Verwendung von CRC bei der Datenübertragung ist es üblich, dass ein nach dem Empfang der Daten berechneter CRC-Prüfwert mit dem vor dem Versand der Daten berechneten CRC-Prüfwert verglichen wird. Dieser vorher berechnete Wert wird zusammen mit den Daten übertragen.

Bei der Datenübertragung, beispielsweise über Ethernet, werden einzelne Datentelegramme übermittelt. Diese setzen sich aus einzelnen Teilen oder Blöcken zusammen, in denen u.a. die Netzwerkadressen von Sender und Empfänger, Kennurigen zum Datentyp, die Daten selbst, Prüfwerte (FCS, frame check sequence) enthalten sind. Abhängig vön der Art der zu übertragenden Daten sind dabei neben den vorhandenen Prüfwerten (z.B. FCS am Ende des Datentelegramms) weitere Prüfwerte innerhalb der Datenfelder notwendig. Werden z.B. Daten zur sicherheitsgerichteten Übertragung verwendet (Schutzklassen nach SIL der IEC 61508), so muss ein zusätzlicher CRC-Prüfwert innerhalb der Datenfelder bzw. - teile generiert werden, dessen Position variabel ist. Sicherheitsgerichtete Übertragung wird zum Schutz von Leib und Leben und zum Maschinenschutz verwendet und bezeichnet eine besonders restfehlerarme Übertragung. Hierzu zählen u.a. Sicherheitsmonitore, Not-Aus-Betätigungen, Türverriegelungen, Lichtgitter/-vorhänge und optische Scanner.

Aufgrund der Vielzahl der durchzuführenden Divisionsoperationen erfordert die Berechnung eines CRC-Prüfwertes einen hohen Aufwand an Rechenzeit. Auch die Erstellung einer geeigneten Software-Routine stellt einen erheblichen Programmieraufwand dar. Im Stand der Technik wird die Anzahl CRC-Berechungen teilweise dadurch verringert, dass Tabellen verwendet werden, in denen zu vorgegebenen Datenblöcken die zugehörigen CRC-Prüfwerte abgelegt werden. Dadurch kann der zeitaufwand für die Berechnung reduziert werden, der Programmieraufwand bleibt aber im wesentlichen erhalten.

Der Erfindung liegt somit die Aufgabe zugrunde, ein Verfahren und eine Vorrichtung anzugeben, mittels derer das Bereitstellen eines CRC-Prüfwertes beschleunigt werden kann.

Diese Aufgabe wird gelöst durch ein Verfahren gemäß Patentanspruch 1 und eine Vorrichtung gemäß Patentanspruch 9. Vorteilhafte Ausgestaltungen sind Gegenstand der Unteransprüche.

### Vorteile der Erfindung

Durch die vorteilhafte Verwendung einer dedizierten Logikschaltung kann eine wesentliche Beschleunigung des Berechnungsverfahrens erreicht werden. Auch werden die Anforderungen an die Softwareprogrammierung vermindert. Es ist vorteilhaft, wenn die Logikschaltung eine Schnittstellenfunktionalität, beispielsweise eine API, bereitstellt. Dieses Verfahren ermöglicht die schnelle Berechnung von CRC-Prüfwerten insbesondere von Datenblöcken in einem Datentelegramm an variablen Positionen. Die Logikschaltung kann als integrierte Schaltung oder Teil einer integrierten Schaltung ausgebildet sein. Sie kann ebenso als ASIC oder FPGA usw. ausgebildet sein. Im Stand der Technik bestehen Logikschaltungen in den meisten Fällen nicht mehr wie früher aus festverdrahteter Logik, sondern aus flexibel programmierbaren Bausteinen (FPGAs, EPLDs, AISCs, Gate Arrays usw.). Diese Bausteine beinhalten keine vorbestimmten Logikfunktionalitäten, sondern stellen eine Art "Logikbaukasten" bereit. Durch Programmierung dieser Bausteine kann eine erwünschte Funktionalität vorgegeben werden.

Herkömmliche Logikbausteine weisen eine vorbestimmte, herstellungs- oder typenbedingte Kapazität auf. In vielen Fällen sind bei bestehenden Schaltungen bereits Logikbausteine vorhanden, deren Kapazität noch nicht vollständig belegt ist. In diesem Fall kann das erfindungsgemäße Verfahren besonders vorteilhaft implementiert werden, da nur geringe oder keine schaltungstechnischen Veränderungen notwendig sind. Damit kann eine Kosteneinsparung erreicht werden. Bei der Datenübertragung werden die Datenblöcke an die Logikschaltung übergeben, die dann selbständig die entsprechenden CRC-Prüfwerte berechnet. Die Übergabe kann beispielsweise seriell oder parallel, über Register usw. erfolgen.

In einer bevorzugten Ausführungsform des erfindungsgemäßen Verfahrens ist ein CRC-Polynom extern vorgebbar. Dies ermöglicht vorteilhaft, die Logikschaltung flexibel verwenden zu können. Es ist mit dieser Lösung nicht notwendig, alle denkbaren Polynome bereits beim Design der Schaltung einzubeziehen. Dadurch wird das Verfahren flexibel gehalten.

Ebenso bevorzugt ist es, wenn bei dem erfindungsgemäßen Verfahren wenigstens ein vorbestimmtes CRC-Polynom integriert ist. Es bietet sich an, die für den geplanten Verwendungszweck benötigten und/oder die bekannten, bei der Beschreibung des Stands der Technik genannten Polynome bereits fest in die Schaltung zu integrieren, wodurch der Programmieraufwand weiter reduziert werden kann.

Es ist zweckmäßig, wenn bei dem erfindungsgemäßen Verfahren eine Länge eines CRC-Polynoms extern vorgebbar ist. Auch mit dieser Ausgestaltung wird die Flexibilität des Verfahrens erhöht.

Ebenso vorteilhaft ist es, wenn bei dem erfindungsgemäßen. Verfahren eine Länge eines CRC-Polynoms durch die Logikschaltung berechnet wird. Dadurch kann vorteilhaft der Programmier- und Implementierungsaufwand verringert werden.

In einer besonders bevorzugten Ausgestaltung des erfindungsgemäßen Verfahrens wird dieses für eine sicherheitsgerichtete Datensicherung verwendet. Damit können Teile des Datenfeldes, insbesondere an variablen Positionen, in einem Datentelegramm mit CRC-Prüfwerten versehen werden, ohne die notwendige Rechenzeit zu erhöhen. Eine beschleunigte Prüfwertberechnung ist insbesondere in diesen Anwendungsfällen vorteilhaft einzusetzen.

Es ist zweckmäßig, wenn das erfindungsgemäße Verfahren für ethernetbasierte Datenübertragung verwendet wird. Ethernetbasierte Datenübertragung ist mittlerweile weit verbreitet und bildet eine Standardausführungsform der Datenübertragung. Das erfindungsgemäße Verfahren kann vorteilhaft in bestehende Systeme integriert werden.

In einer besonders bevorzugten Ausführungsform wird das erfindungsgemäße Verfahren in einem Netzwerk nach einem SERCOS-Standard verwendet. Beispielsweise kann ein Netzwerk nach dem SERCOS III-Standard verwendet werden, der die Verwendung von Ethernet-Komponenten bei einer SERCOS-Verbindung erlaubt.

In einem bevorzugten Ausführungsbeispiel des erfindungsgemäßen Verfahrens wird dieses für Echtzeitdatenübertragung bzw. Echtzeitkommunikation verwendet. Besonders bei der Echtzeitkommunikation wirkt sich die beschleunigte CRC-Prüfwertberechnung vorteilhaft aus.

Bei einer erfindungsgemäßen Logikschaltung ist diese zur Berechnung von CRC-Prüfwerten für Datenblöcke bei einer Datenübertragung dediziert ausgebildet. Dadurch kann eine schnelle CRC-Prüfwertberechnung bereitgestellt werden.

In einer bevorzugten Ausgestaltung ist die erfindungsgemäße Logikschaltüng geeignet, ein erfindungsgemäßes Verfahren auszuführen.

Es ist besonders zweckmäßig, wenn die erfindungsgemäße Logikschaltung in einen Kommunikationscontroller integriert ist. Kommunikationscontroller werden für die Datenübertragung verwendet und stellen verschiedene Funktionalitäten für die Datenübertragung bereit. Durch die zusätzliche Integration der Logikschaltung kann eine vorteilhafte Platzersparnis erzielt werden. Es versteht sich, dass die erfindungsgemäße Logikschaltung ebenso in andere Logikbausteine integrierbar ist.

Ebenso vorteilhaft ist es, wenn die erfindungsgemäße Logikschaltung als integrierter Schaltungsbaustein ausgebildet ist. Dadurch kann sie zusätzlich zu vorhandenen Bausteinen oder Controllern verwendet werden und in bestehende Systeme eingesetzt werden.

Es ist von Vorteil, wenn die erfindungsgemäße Logikschaltung zertifiziert oder vorzertifiziert ist. Insbesondere sicherheitsgerichtete Systeme werden im Stand der Technik beispielsweise von Berufsgenossenschaften zertifiziert. Dies ist mit Aufwand und Kosten verbunden. Soll eine erfindungsgemäße Logikschaltung beispielsweise in einem sicherheitsgerichteten Umfeld verwendet werden, ist es vorteilhaft, wenn die Logikschaltung bereits zertifiziert oder vorzertifiziert ist. Damit kann der nachträgliche Zertifizierungsaufwand verringert werden. Für eine Zertifizierung wird die Logikschaltung in einer Logik- bzw. Hardwarebeschreibungssprache beschrieben, beispielsweise in VHDL-Code. Dieser Code wird dann dem Zertifizierungsverfahren zugeführt.

Weitere Vorteile und Ausgestaltungen der Erfindung ergeben sich aus der Beschreibung und der beiliegenden Zeichnung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Figurenbeschreibung

Im Folgenden sollen die Erfindung und insbesondere deren Vorteile anhand eines in den Figuren dargestellten Ausführungsbeispiels näher erläutert werden.

Es zeigt
- Figur 1a: ein Flussdiagramm einer Datenübertragung, bei der Datenfelder mit CRC-Prüfwerten versehen werden, im Stand der Technik;
- Figur 1b: ein Flussdiagramm entsprechend Figur 1a, wobei ein Ausführungsbeispiel eines erfindungsgemäßen Verfahrens verwendet wird;
- Figur 2: eine schematische Darstellung einer Ausführungsform einer erfindungsgemäßen Logikschaltung; und
- Figur 3: den Aufbau eines Masterdatentelegramms nach dem SERCOS III-Standard, wobei eine Ausführungsform des erfindungsgemäßen Verfahrens verwendet wird.

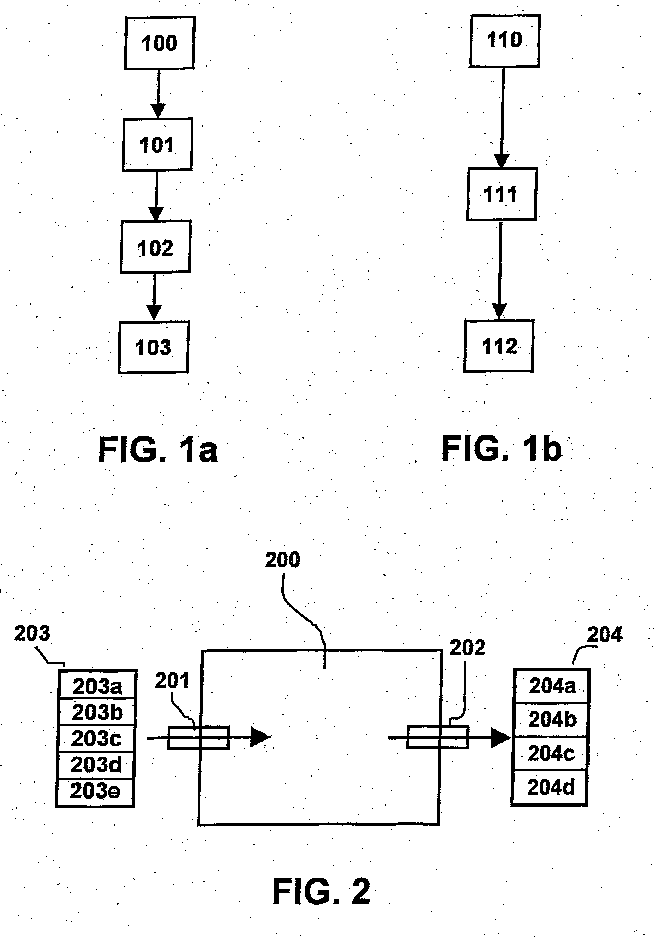

In Figur 1a wird ein Flussdiagramm einer Datenübertragung im Stand der Technik gezeigt, wobei ausgewählte Datenfelder mit CRC-Prüfwerten versehen werden.

Im Verfahrensschritt 100 werden die zu übertragenden Daten vorbereitet. Dazu gehört unter anderem die Einteilung der Daten in Datenblöcke, wobei einzelne Datenblöcke in Datentelegrammen übertragen werden.

Im Schritt 101 wird zu jedem Datenblock der zugehörige CRC-Prüfwert berechnet. Dies erfolgt im Stand der Technik durch Softwareroutinen, die auf Grund der beschriebenen Anforderungen eine relativ lange Zeitdauer in Anspruch nehmen.

Im Verfahrensschritt 102 werden dann die Datenblöcke mit den berechneten CRC-Prüfwerten zusammengefasst. Die zusammengefassten Daten werden schließlich im Verfahrensschritt 103 an den Kommunikationscontroller übergeben. Der Kommunikationscontroller führt die anschließende Datenübertragung weitgehend selbständig durch.

In Figur 1b ist ein dem in Figur 1a gezeigten Flussdiagramm entsprechendes Flussdiagramm dargestellt, wobei ein Ausführungsbeispiel des erfindungsgemäßen Verfahrens verwendet wird.

In Schritt 110 werden wiederum die zu übertragenden Daten in einzelne Datenblöcke unterteilt. Im Verfahrensschritt 111 wird die zur Berechnung von CRC-Prüfwerten dedizierte Logikschaltung initialisiert und konfiguriert. Dabei wird der Logikschaltung u.a. das zu verwendende CRC-Polynom, die Länge des zu verwendenden CRC-Polynoms und die Position der Datenblöcke mitgeteilt, für die CRC-Prüfwerte berechnet werden sollen.

Im Verfahrensschritt 112 sind nur noch die Datenblöcke der Logikschaltung bzw. einem Kommunikationscontroller, der eine integrierte Logikschaltung aufweist, zu übergeben. Vor der anschließenden Datenübertragung führt die Logikschaltung bzw. die in den Kommunikationscontroller integrierte Logikschaltung die CRC-Prüfwertberechnung selbständig durch. Auf diese Weise kann das Verfahren beschleunigt werden.

In Figur 2 ist eine Ausführungsform einer erfindungsgemäßen Logikschaltung insgesamt mit 200 bezeichnet. Die Logikschaltung 200 weist einen Eingang 201 und einen Ausgang 202 auf. Der Eingang 201 und der Ausgang 202 können für serielle oder parallele Datenübermittlung ausgebildet sein, wie es im Stand der Technik hinreichend bekannt ist. Es versteht sich, dass es sich bei dem Eingang 201 und dem Ausgang 202 nicht um physikalisch in dieser Form ausgebildete Bauteile, wie z.B. Stecker usw., handeln muss, sonder dass ebenso Ein- und Ausgänge einer logischen Schnittstellenbeschreibung von dieser Beschreibung umfasst sind.

An den Eingang 201 werden Eingabedaten 203 bereitgestellt. Die Eingabedaten 203 enthalten verschiedene Datenbereiche bzw. Datenblöcke 203a bis 203e. In dieser schematischen. Darstellung entspricht die Unterteilung der Eingabedaten 203 in.einzelne Blöcke nicht unbedingt einer zeitlichen, räumlichen oder andersartigen Unterteilungen, sondern stellt vor allem eine schematische Unterteilung dar.

Die Eingabedatenblöcke 203a bis 203e enthalten zum einen die Konfigurationsdaten, die zur Initialisierung und Konfiguration der Logikschaltung 200 notwendig sind, und zum anderen die Daten, für die eine CRC-Prüfwertberechnung stattfinden soll. Beispielsweise enthält der Eingabedatenblock 203a das zu verwendende CRC-Polynam, der Eingabedatenblock 203b die Länge des zu verwendenden CRC-Polynoms, der Eingabedatenblock 203c die Menge oder Anzahl der Daten, für die die CRC-Prüfwertberechnung erfolgen soll, und die Eingabedatenblöcke 203d und 203e die Daten, für die die CRC-Prüfwertberechnung erfolgen soll.

Die Eingabedatenblöcke 203a bis 203e werden als Eingabedaten 203 an den Eingang 201 übergeben. Die Logikschaltung 200 berechnet dann entsprechend ihrer Konfiguration für die übergebenen Daten die zugehörigen CRC-Prüfwerte.

Die Logikschaltung 200 stellt schließlich an ihrem Ausgang 202 die Ausgabedaten 204.bereit. In diesem Ausführungsbeispiel enthalten die Ausgabedaten 204 Ausgabedatenblöcke 204a bis 204d. Die Anzahl der Ausgabedatenblöcke wird vorzugsweise durch die Anzahl der Eingabedatenblöcke bestimmt. In diesem Beispiel werden für die zwei Eingabedatenblöcke 203d und 203e jeweils ein CRC-Prüfwert berechnet. Die Eingabedatenblöcke 203d und 203e werden als Ausgabedatenblöcke 204a bzw. 204'c ausgegeben, wobei die zugehörigen CRC-Prüfwerte 204b bzw. 204d jeweils als weitere Ausgabedatenblöcke eingefügt werden.

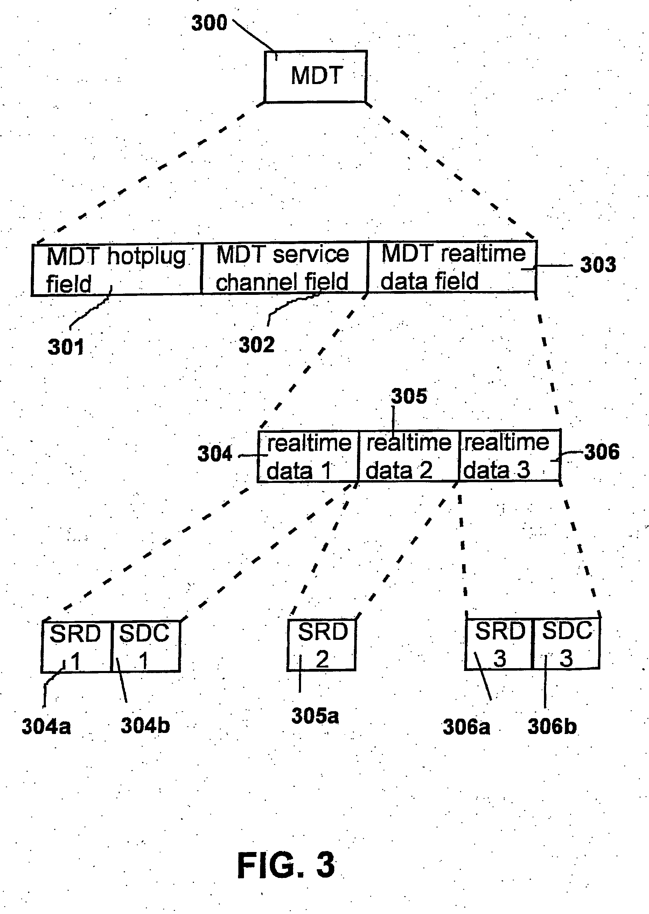

Auf diese Weise kann eine schnelle CRC-Prüfwertberechnung für variable Datenblöcke erreicht werden, wie sie insbesondere bei einer Datenübertragung nach dem SERCOS III-Standard auftreten, wie näher anhand Figur 3 erläutert wird.

In Figur 3 ist der Aufbau eines beispielhaften Masterdatentelegramms (MDT) nach dem SERCOS III-Standard schematisch gezeigt.

Bei SERCOS handelt es sich um eine standardisierte Servoantriebsschnittstelle mit Feldbuskopplern. Das Anwendungsspektrum umfasst neben spanenden Bearbeitungstechnologien auch andere Automatisierungslösungen z.B. auf dem Gebiet der Montageroboter, sowie von Druck- und Verpackungsmaschinen.

Der Zugriff auf das Übertragungsmedium wird durch ein Zeitschlitzverfahren realisiert. Dabei wird jedem Teilnehmer ein Zeitpunkt zugeordnet, an dem er exklusiv das Zugriffsrecht auf das Übertragungsmedium besitzt.

Der Kommunikationszyklus wird durch das Mastersynchronisationstelegramm (MST) des Masters, z.B. ein Steuerungssystem, gestartet. Die Slaves, z.B. Antriebssysteme oder E/A-Stationen, senden nacheinander jeweils ein Antriebstelegramm (AT) mit ihren momentanen Istwerten. Im Anschluss sendet der Master das Masterdatentelegramm (MDT) mit den Sollwerten. Dieser Ablauf wiederholt sich in jedem Kommunikationszyklus. Alle Datentelegramme werden von allen Slaves empfangen. Ein MDT enthält daher Daten für alle anzusteuernden Slaves.

Ein MDT Feld (MDT data field) 300 weist drei Bereiche 301, 302, 303 auf, wobei der Bereich 301 als' "MDT hotplug field", der Bereich 302 als "MDT service channel field" und der Bereich 303 als "MDT realtime data field" bezeichnet wird. Der Bereich 303 (MDT realtime data field) enthält die Echtzeitdaten, die an alle anzusteuernden Slaves übertragen werden.

In dem gezeigten Beispiel weist der Bereich 303 drei innere Bereiche 304, 305 und 306 auf, die jeweils Echtzeitdaten für unterschiedliche angeschlossene Slaves beinhalten. In diesem Beispiel sind Daten für drei angeschlossene Slaves enthalten, weshalb die Bereiche 304, 305 und 306 als "realtime data 1", "realtime data 2" und "realtime data 3" bezeichnet werden. Die Anzahl der Slaves, für die Daten übertragen werden, kann sich bei jedem Übertragungszyklus ändern.

Abhängig vom Verwendungszweck der angesprochenen Slaves weisen die Bereiche 304, 305, 306 wiederum einen unterschiedlichen inneren Aufbau auf.

In dem gezeigten Beispiel, weist der Bereich 304 (realtime data 1) zwei Bereiche 304a und 304b auf, die als "standard realtime data 1" (SRD 1) und "safe data container 1" (SDC 1) bezeichnet werden.

Der Bereich 305 (realtime data 1) weist einen Bereich 305a (SRD 1) auf, der Bereich 306 (realtime data 3) weist einen Bereich 306a (SRD 3) und einen Bereich 306b (SDC 3) auf. In den Bereichen 304a (SRD 1), 305a (SRD 2) und 306a (SRD 3) sind die Daten für die jeweiligen Slaves enthalten, die keine erhöhte Fehlersicherheit aüfweisen müssen. In den Bereichen 304b (SDC 1) und 306b (SDC 3) hingegen sind die Daten enthalten, die eine erhöhte Fehlersicherheit aufweisen. Zur Bereitstellung der erhöhten Fehlersicherheit werden CRC-Prüfwerte hinzugefügt.

Im Stand der Technik werden die CRC-Prüfwerte für die Bereiche 304b und 306b über Softwareroutinen berechnet. Der Inhalt der Bereiche 304a, 305a, 306a und der Bereiche 304b und 306b variiert normalerweise bei jedem Übertragungszyklus. Auch sind die Unterteilungen des Bereichs 303 (MDT realtime data field) in die Bereiche 304 (realtime data 1), 305 (realtime data 2) und 306 (realtime data 3) nur beispielhaft und variieren ebenfalls von Anwendung zu Anwendung. Auch ist die Anzahl der genannten Unterteilungen nicht konstant.

Aus diesen Gründen müssen die CRC-Prüfwerte in jedem Übertragungszyklus erneut berechnet werden. Dies nimmt in jedem Übertragungszyklus eine lange Zeitdauer in Anspruch.

Durch Verwendung einer bevorzugten Ausführungsform des erfindungsgemäßen Verfahrens zur Berechnung der CRC-Prüfwerte, die in die variierenden Bereichen "SDC" hinzugefügt werden, kann eine wesentliche Zeitersparnis erreicht werden.

### Bezugszeichen

- 101 - 103: Verfahrensschritt
- 110 - 112: Verfahrensschritt
- 200: Logikschaltung
- 201: Eingang
- 202: Ausgang
- 203: Eingabedaten
- 203a - 203e: Eingabedatenblock
- 204: Ausgabedaten
- 204a - 204d: Ausgabedatenblock
- 300: MDT Feld
- 301: MDT hotplug field
- 302: MDT service channel field
- 303: MDT realtime data field
- 304: realtime data 1
- 304a: standard realtime data 1
- 304b: safe data container 1
- 305: realtime data 2
- 305a: standard realtime data 2
- 306: realtime data 3
- 306a: standard realtime data 3
- 306b: safe data container 3

## Patentansprüche

1. Verfahren zur Berechnung von CRC-Prüfwerten (204b, 204d) für Datenblöcke (203d, 203e) bei einer Datenübertragung,
**dadurch gekennzeichnet, dass**
eine dedizierte Logikschaltung (200) für die Berechnung verwendet wird.

2. Verfahren nach Anspruch 1, **dadurch gekennzeichnet, dass** ein CRC-Polynom extern vorgebbar ist.

3. Verfahren nach einem der vorstehenden Ansprüche, **dadurch gekennzeichnet, dass** wenigstens ein vorbestimmtes CRC-Polynom in der-Logikschaltung (200) integriert ist.

4. Verfahren nach einem der vorstehenden Ansprüche, **dadurch gekennzeichnet, dass** eine Länge eines CRC-Polynoms extern vorgebbar ist.

5. Verfahren nach einem der vorstehenden Ansprüche, **dadurch gekennzeichnet, dass** eine Länge eines CRC-Polynoms durch die Logikschaltung (200) berechnet wird.

6. Verwendung eines Verfahrens nach einem der vorstehenden Ansprüche für eine sicherheitsgerichtete Datensicherung.

7. Verwendung eines Verfahrens nach einem der vorstehenden Ansprüche für eine ethernetbasierte Datenübertragung.

8. Verwendung eines Verfahrens nach einem der vorstehenden Ansprüche in einem Netzwerk nach einem SERCOS-Standard.

9. Verwendung eines Verfahrens nach einem der vorstehenden Ansprüche für Echtzeitdatenübertragung.

10. Logikschaltung (200)
**dadurch gekennzeichnet, dass**
die Logikschaltung (200) zur Berechnung von CRC-Prüfwerten (204b, 204d) für Datenblöcke (203d, 203e) bei einer Datenübertragung dediziert ist.

11. Logikschaltung (200) nach Anspruch 10, **dadurch gekennzeichnet, dass** sie in einen Kömmunikationscontroller integriert ist.

12. Logikschaltung (200) nach einem der Ansprüche 10 oder 11, **dadurch gekennzeichnet, dass** sie als integrierter Schaltungsbaustein ausgebildet ist.

13. Logikschaltung (200) nach einem der Ansprüche 10 bis 12, **dadurch gekennzeichnet, dass** sie zertifiziert oder vorzertifiziert ist.

14. Verwendung einer Logikschaltung (200) nach einem der Ansprüche 10 bis 13 zur Durchführung eines Verfahrens nach einem der Ansprüche 1 bis 9.
